# EUROPEAN PATENT APPLICATION

(11) **EP 3 739 386 A1**
(43) Date of publication of application: **18.11.2020**
(21) Application number: 19174399.6
(22) Date of filing: 14.05.2019
(51) Int. Cl.: G03F 7/00, G03F 7/075, G03F 7/028

(54) **A STAMP MATERIAL FOR NANOLITHOGRAPHY**

(71) Applicant: OpTool AB, 247 62 Veberöd (SE)
(72) Inventor: Heidari, Babak, 247 62 Veberöd (SE)
(74) Representative: KIPA AB

(57) **Abstract**

The disclosure relates to a stamp material for imprint lithography, characterized in that it is made of a cyclic siloxanes pre-polymer.

## Description

### BACKGROUND OF THE INVENTION

### Field of the Invention

This disclosure pertains to a polymer to be used for nanolithography, such as imprint lithography techniques. The polymer may be used for stamps or molds, such as elastomeric stamps or moulds. Especially, the disclosure relates to a polymer which eliminate needs for surface treatment.

### Description of the Prior Art

Nanolithography is the branch of nanotechnology concerned with the study and application of fabricating nanometer-scale structures, meaning patterns with at least one lateral dimension between 1 and 1,000 nm. Different approaches can be categorized in serial or parallel, mask or maskless/direct-write, top-down or bottom-up, beam or tip-based, resist-based or resist-less methods.

Imprint lithography, and its variants, such as Step- and-Flash Imprint Lithography, LISA, Soft lithography and LADI are promising nanopattern replication technologies where patterns are created by mechanical deformation of imprint resist, typically a monomer or polymer formulation that is cured by heat or UV light during imprinting. This technique can be combined with contact printing and cold welding.

In most of the imprint lithography techniques, elastomeric stamps/moulds is used for fabricating or replicating structures into a resist coated on a substrate.

Polydimethylsiloxane (PDMS), also known as dimethylpolysiloxane or dimethicone, PDMS is commonly used as a stamp resin in imprint lithography, making it one of the most common materials used for replication of structures. The process of imprint lithography consists of creating an elastic stamp, which enables the transfer of patterns of only a few nanometers in size onto ceramics, glass, silicon, metal or polymer surfaces. With this type of technique, it is possible to produce devices that can be used in the areas of optic telecommunications, biomedical, LED, semiconductor lasers, photovoltaic and many other application areas. The master stamp is produced from the normal techniques of photolithography or electron-beam lithography. The resolution depends on the master stamp used and can reach structure below 6 nm.

The PDMS stamp/mould is produced by poured over a master stamp (usually patterned silicon) and left to harden. When removed, even the smallest of details is left imprinted in the PDMS. The imprinted surface is now modified with Plasma treatment to make the surface hydrophobic with antiadhesive behaviour. This PDMS stamp may thereafter be placed onto a polymer coated substrate to replicate the structure from the PDMS stamp into the resist layer.

Alkylsilanes (silanes) have long been used for tailoring a wide variety of surfaces including silicates, aluminates, and titanates. They are currently used on an industrial scale for a wide variety of applications, such as coupling agents for glasses and polymers, as adhesion promoters, as cross-linking and dispersing agents, and for hydrophobization. Silanes readily react with surfaces through surface hydroxyl groups, or bound water to form a strongly bound coating that includes both covalent bonds and multiple van der Waals interactions.

Silanization is the covering of a surface with organofunctional alkoxysilane molecules. Mineral components like glass and metal oxide surfaces can all be silanized, because they contain hydroxyl groups which attack and displace the alkoxy groups on the silane thus forming a covalent -Si-O-Si- bond. The goal of silanization is to form bonds across the interface between mineral components and organic components present in paints, adhesives, etc. Silanization (or siliconization) of glassware increases its hydrophobicity.

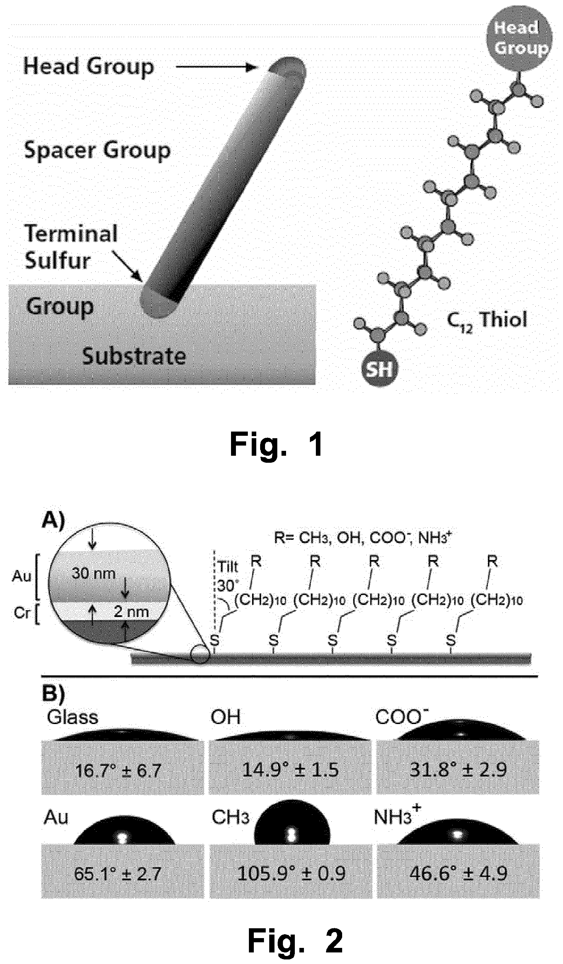

Surface modification also made using Alkanethiol self-assembled monolayer (SAM). The surfaces will be covered by only one mono-layer which can be functionalized dependent of the application and needs, see Figure 1 and 2.

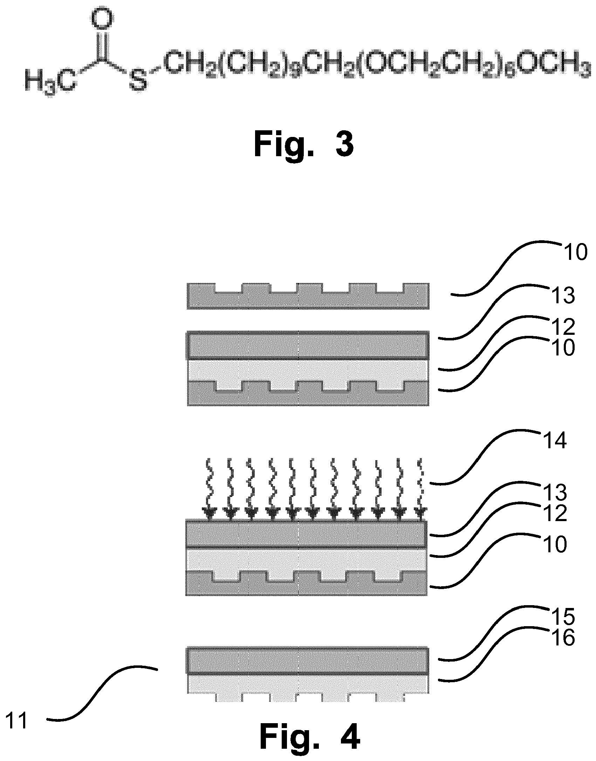

In practice, the head groups of -CH3 will make the surface highly hydrophobic. For example using (1-(Methylcarbonylthio)undec-11-yl)hexa(ethylene glycol)monomethyl ether, C26H52O8S , the surface will act as antiadhesive surface, see Figure 3 which is illustrating a Chemical structure of 1-(Methylcarbonylthio)undec-11-yl)hexa(ethylene glycol)monomethyl ether.

In early stage of Imprint lithography, the Alkanethiol was used to modify the surface of the stamp/mould antiadhesive. In continuation Silanes with fluor thermination was used which give much better antiadhesive properties. For example SAMs of PFOTS, Trichloro(1H,1H,2H,2H-perfluorooctyl)silane, is used on Silicon master wafers to fabricate poly (dimethyl siloxanes) (PDMS) mould, hence forming an antiadhesive layer and easy release of cured PDMS.

In addition, the PDMS stamp/mould must also be treated with SAMs of PFOTS to have antiadhesive surface against polymers for final imprints.

In practice PDMS manufacturing is very time consuming and it is difficult to realize as high throughput production technique.

### SUMMARY OF THE DISCLOSURE

Accordingly, embodiments of the present disclosure preferably seek to mitigate, alleviate or eliminate one or more deficiencies, disadvantages or issues in the art, such as the above-identified, singly or in any combination by providing a polymer for stamps, molds, material and processing. The sensor may be an optical sensor. The described polymers may be a replacement of traditional Polydimethylsiloxane (PDMS) stamps/molds with imbedded antiadhesive surface.

In a first aspect, the stamp material for imprint lithography, may be made of polymeric cyclic siloxane with at least one Oxide termination arm and at least three -CH3 termination arms.

In a further aspect, the stamp material for imprint lithography, may be made of a cyclic siloxanes pre-polymer

In some examples, cyclic siloxanes pre-polymer may be a polymeric cyclic siloxane with at least one Oxide termination arm and at least three -CH3 termination arms.

In some examples, cyclic siloxanes pre-polymer may be a cyclic oligomeric siloxanes.

In some example, the cyclic oligomeric siloxane may be copolymerized with acrylates or epoxies. An example of a acrylate is (Meth)acrylates, such as 1.6-Hexanediol diacrylate, and an example of an epoxy is glycidyl ethers, such as Dodecyl and tetradecyl glycidyl ethers.

In some example, the Young's modulus may be ≥4 Mpa after polymerization.

In yet another aspect, a stamp for imprint lithography is described. The stamp includes a cured stamp material, such as a cyclic siloxanes pre-polymer, such as a polymeric cyclic siloxane with at least one Oxide termination arm and at least three -CH3 termination arms, such as a cyclic oligomeric siloxanes.

In some examples, the stamp includes a first part being a carrying foil, the first part being made of a polymeric foil, and a second part for providing conformal contact of the stamp and substrate surface to be printed on, the second part be made of the cured stamp material.

In some examples, the carrying foil may be made of light transparent materials. The carrying foil may be, for example, made of PET, PC or and other UV transparent polymer materials.

In some examples, the carrying foil may be made of glass or ceramics or any transparent materials.

In some example, the first part may have a front face for printing and a back face opposite the front face. The second part may be arranged on the back face of the first part such that the first part is at least partially embedded in the second part.

In some example, the second part may provide a margin extending beyond the first part, preferably all-around the first part. The margin may allow for conformal contact with a surface to be printed on.

In some examples, the front face may have a structured surface for printing.

In some examples, the cured stamp material, such as a cured cyclic oligomeric siloxanes polymer, may be based on, for example, any of Hexamethylcyclotrisiloxane, Octamethylcyclotetrasiloxane, Methacrylate epoxy cyclosiloxane, Polyglycidyl ether cyclosiloxane, or Acrylated Hexamethylcyclotrisiloxane.

Some expects of the description relates to a method of obtaining a stamp for imprint lithography. The method includes curing a cyclic siloxanes pre-polymer, such as a polymeric cyclic siloxane with at least one Oxide termination arm and at least three -CH3 termination arms, to form the stamp.

It should be emphasized that the term "comprises/comprising" when used in this specification is taken to specify the presence of stated features, integers, steps or components but does not preclude the presence or addition of one or more other features, integers, steps, components or groups thereof.

### BRIEF DESCRIPTION OF THE DRAWINGS

These and other aspects, features and advantages of which examples of the disclosure are capable of will be apparent and elucidated from the following description of examples of the present disclosure, reference being made to the accompanying drawings, in which:
Fig. 1 is illustrating a schematic of an Alkanethiol.
Fig. 2A is illustrating an Alkanethiol self-assembled monolayer (SAM)
Fig. 2B is illustrating water wetting for various head groups.
Fig. 3 is illustrating a Chemical structure of 1-(Methylcarbonylthio)undec-11-yl)hexa(ethylene glycol)monomethyl ether.
Fig. 4 is illustrating a schematic process for replication of structure from a master stamp to a polymeric stamp.
Fig. 5 is illustrating a schematic structure of Acrylated Hexamethylcyclotrisiloxane.
Fig. 6 is illustrating a schematic process for final imprint on a substrate using polymer stamp.
Fig. 7 is illustrating an exemplary flow-chart of obtaining a stamp for imprint lithography.

### DESCRIPTION OF EXAMPLES

Specific examples of the disclosure will now be described with reference to the accompanying drawings. This disclosure may, however, be embodied in many different forms and should not be construed as limited to the examples set forth herein; rather, these examples are provided so that this disclosure will be thorough and complete, and will fully convey the scope of the disclosure to those skilled in the art.

The following disclosure focuses on examples of the present disclosure applicable to nanolithography, such as imprint lithography techniques. The disclosure relates to a solution to solve issues with polymer stamps, material and processing. In particularly to make the processing simples and faster.

The innovation is describing to use a Silane with termination of -CH3 groups and polymerized to form cyclic dimethylsiloxanes in acrylate or epoxy forms. This new polymers may replace traditional PDMS stamps/molds with imbedded antiadhesive surface. The described Silane based polymers may eliminate all needs for surface treatment which are needed for traditional PDMS stamps/molds to obtain an imbedded antiadhesive surface. The described polymer also has improved wetting to master mold and stamp.

The described Silene based polymers may have UV-curing possibility which makes the described polymers fast and compatible for industrially use. The UV-curing may be provided by polymerization with UV-curable acrylates or epoxies. This may for example be monomers or pre-polymers, i.e. the stamp material, in conjunction with a photo-initiator. The type of photo-initiator used depends on the wavelength wanted from the light source used for curing the stamp.

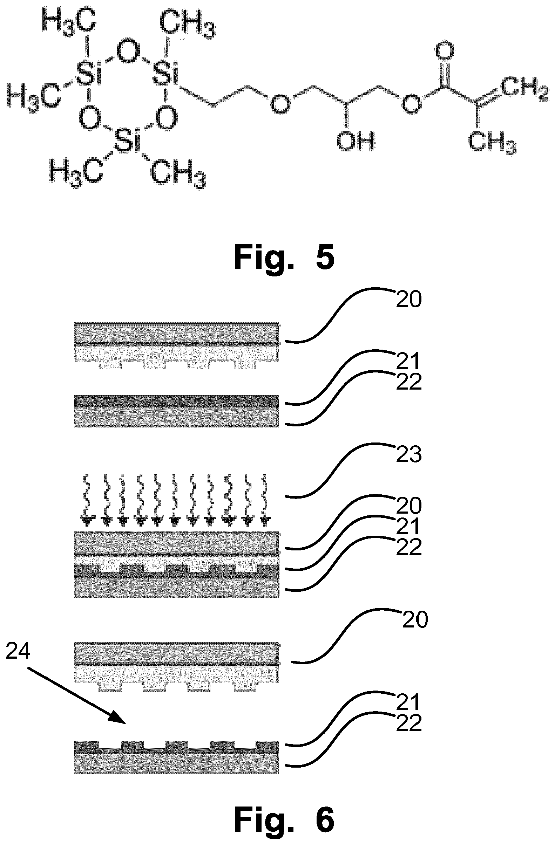

The disclosure relates to any combination of the following chemical in polymerization with UV-curable acrylates or epoxies: Hexamethylcyclotrisiloxane, Octamethylcyclotetrasiloxane, Methacrylate epoxy cyclosiloxane, Polyglycidyl ether cyclosiloxane and Acrylated Hexamethylcyclotrisiloxane. The chemical may not be limited only to above mention chemicals. Figure 5 is, for example, illustrating a schematic structure of Acrylated Hexamethylcyclotrisiloxane.

The polymers made with these combinations may replicate structures from a master stamp by UV-curing and crosslinking of the polymer chains. The cured polymer film may easily be remove from the e.g. silicon stamp/mould
Figure 4 is illustrating a schematic process 100 for replication of structure from a master stamp 10 to a polymeric stamp 11. The process may start with a master stamp 10. A cyclic siloxane based polymer 12, such as a UV-curable cyclic, may be arranged on a master stamp 10, alternatively the master stamp 10 may be pressed into the polymer 12. The polymer 12 may be arranged on a substrate 13, such as a carrier foil. When the polymer 12 is provided arranged on the substrate 13, a protection layer or foil, not illustrated, may be arranged on the surface of the polymer 12 to be arranged on top of the mater stamp 10. The protection layer or foil has to be removed before the polymer 12 and carrier foil 13 is being arranged on the master stamp 10.

Alternatively, a substrate 13 may be arranged on top of the polymer 12 after it has been arranged on the master stamp 10. For example, may the polymer 12 be poured on-top of the master stamp 10 and then may the substrate 13 be arranged on the polymer 12.

UV radiation 14 may then be used to cure the polymer 12. The UV radiation may be illuminating the polymer 12 through the substrate 13. After the stamp 11 has cured, the master stamp 10 is removed and the pattern of the master stamp 10 has been imprinted into the polymer 12 to the obtained polymer stamp 11. In some examples, the polymer 12 may be partly-cured before being arranged in the master stamp 10 and then fully cured when arranged thereon. By utilizing the described polymers 12, the Silane based polymer stamp 11 does not need any surface treatment to modify the surface characteristic. The surface has an antiadhesive property against most of the acrylates and epoxy resins used as final imprint resists.

In some examples, the carrying foil 13 may be made of light transparent materials. The carrying foil 13 may be, for example, made of PET, PC or and other UV transparent polymer materials.

In some examples, the carrying foil 13 may be made of glass or ceramics or any transparent materials.

The polymer stamp 11 may be described as, a first part 15 being a carrying foil 13. The first 15 part may be made of a polymeric foil. A second part 16 for providing conformal contact of the stamp 11 and substrate surface to be printed on. The second part 16 may be made of the cured stamp material 12. In some example, the first part 15 may have a front face for printing and a back face opposite the front face. The second part 16 may be arranged on the back face of the first part 15 such that the first part 15 is at least partially embedded in the second part 16.

In some example, the second part 16 may provide a margin extending beyond the first part 15, preferably all-around the first part 15. The margin may allow for conformal contact with a surface to be printed on.

Figure 6 is illustrating a schematic process for final imprint on a substrate using polymer stamp 20. The Polymer stamp 20 may be pressed into a resist made from a resin 21, for example a UV-curable resin. The resist may be arranged on a substrate 22. When the polymer stamp 20 is pressed into the resist 21, UV radiation 23 may be illuminating the resist 21 to make it cure. The polymer stamp 20 and the cured resin 21 may be separated and a pattern 24 has been transferred to the polymer layer 21 on the substrate 22.

Below are two examples given. The tests are made using cyclic oligomeric siloxanes. The polymerization made using photo activation for crosslinking to a solid polymer film. The final polymeric stamp/mould showed antiadhesive surface with capability to replicate the structure down to sub-100 nm in acrylate and epoxy layers coated on silicon wafer surface, see figure 6.

### Example 1:

Hexamethylcyclotrisiloxane was added to a modified acrylate resin, such as 1.6-Hexanediol diacrylate, and mixed with 3% (w) TPO-photoinitiator under stirring and heated to about 120°C and then cooled down to 25°C. This combination can make the crosslinking at wavelength of 365nm and energy to cure the polymer is about 400mJ/cm2.

The above polymer mix was spin coated on a master stamp (patterned Silicon wafer). A PET-foil of 75micro meter thickness was laminated (NO pressure applied) on the coated master stamp. A LED based flood-exposure unit (wavelength 365nm) was used to crosslink and cure the resin.

The polymer film was delaminated from the master stamp easily with force below 20 g/25 mm and produced a polymer stamp. A silicon substrate was coated with UV-curable epoxy resist (DELO 119119). The polymer stamp laminated on the coated silicon substrate with low pressure of 0.3 bars. The UV-curable epoxy resist was cured using LED based flood-exposure unit with energy about 1200mJ/cm2. The polymer stamp was delaminated from the Silicon substrate easily with force below 20 g/25 mm and produced a patterned substrate.

All structure was successfully replicated into the epoxy resist coated on silicon substrate and there were no rip-off or defects observed.

### Example 2:

Hexamethylcyclotrisiloxane was added to a modified acrylate resin, such as 1.6-Hexanediol diacrylate, and mixed with 2% (w) TPO-photoinitiator under stirring and heated to about 120°C and then cooled down to 25°C. This combination can make the crosslinking at wavelength of 365nm and energy to cure the polymer is about 600mJ/cm2.

The above polymer mix was spin coated on a PET-foil of 500 micro meter thickness. The coated PET-foil was laminated on a master stamp (patterned Silicon wafer). A LED based flood-exposure unit (wavelength 365nm) was used to crosslink and cure the resin.

The polymer film was delaminated from the master stamp easily with force below 20 g/25 mm and produced a polymer stamp. A silicon substrate was coated with UV-curable epoxy resist (DELO 119119). The polymer stamp laminated on the coated silicon substrate with low pressure of 0.3 bars. The UV-curable epoxy resist was cured using LED based flood-exposure unit with energy about 1200mJ/cm2. The polymer stamp was delaminated from the Silicon substrate easily with force below 20 g/25 mm and produced a patterned substrate.

All structure was successfully replicated into the epoxy resist coated on silicon substrate and there were no rip-off or defects observed.

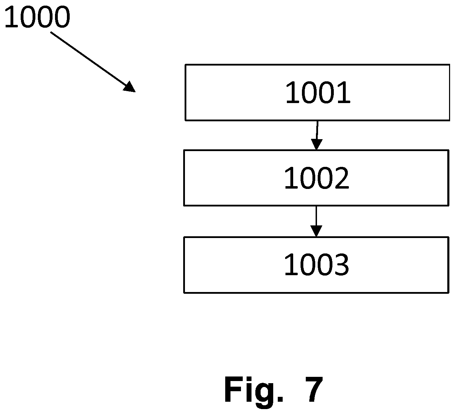

Figure 7 is illustrating an exemplary flow-chart 1000 of obtaining a stamp for imprint lithography. The method includes curing 1002 a cyclic siloxanes pre-polymer as described herein, such as a polymeric cyclic siloxane with at least one Oxide termination arm and at least three -CH3 termination arms, to form the stamp.

The Method may be initiated by arranging 1001 the cyclic siloxanes pre-polymer on a master stamp. This may be done as previously described herein, such as either by pouring the polymer over the stamp or arranging the polymer on a substrate before contacting the master stamp with the polymer.

While the polymer is in contact with the master stamp, the polymer may be cured by for example UV radiation thereby curing 1002 the polymer.

The master stamp is then removed whereby a polymer stamp is obtained 1003.

The polymer stamp may be used to obtain imprints as described in relation to figure 6. Each polymer stamp may be used multiple times.

The present disclosure has been described above with reference to specific examples. However, other examples than the above described are equally possible within the scope of the disclosure. Different method steps than those described above, performing the method by hardware or software, may be provided within the scope of the invention. The different features and steps of the invention may be combined in other combinations than those described. The scope of the disclosure is only limited by the appended patent claims.

The indefinite articles "a" and "an," as used herein in the specification and in the claims, unless clearly indicated to the contrary, should be understood to mean "at least one." The phrase "and/or," as used herein in the specification and in the claims, should be understood to mean "either or both" of the elements so conjoined, i.e., elements that are conjunctively present in some cases and disjunctively present in other cases.

## Claims

1. A stamp material for imprint lithography, **characterized in that** it is made of a cyclic siloxanes pre-polymer.

2. The stamp material for imprint lithography, wherein said cyclic siloxanes pre-polymer is a polymeric cyclic siloxane with at least one Oxide termination arm and at least three -CH3 termination arms.

3. The stamp material according to any of claims 1 or 2, wherein said cyclic siloxanes pre-polymer is cyclic oligomeric siloxanes.

4. The stamp according to claim 3, wherein said cyclic oligomeric siloxane is copolymerized with acrylates or epoxies.

5. The stamp material according to any of claims 1 to 4, **characterized in that** it has a Young's modulus ≥4 Mpa after polymerization.

6. A stamp for imprint lithography, comprising a cured stamp material according to any of claims 1 to 5.

7. The stamp according to claim 6, comprising a first part being a carrying foil, said first part being made of a polymeric foil, and a second part for providing conformal contact of the stamp and substrate surface to be printed on, said second part be made of said cured stamp material.

8. The stamp according to claim 7, wherein carrying foil is made of light transparent materials.

9. The stamp according to any of claims 7 or 8, wherein carrying foil is made of PET, PC or and other UV transparent polymer materials.

10. The stamp according to any of claims 7 to 9, wherein carrying foil is made of glass or ceramics or any UV transparent materials.

11. The stamp according to any of claims 6 to 10, wherein the cured stamp material is based on any of Hexamethylcyclotrisiloxane, Octamethylcyclotetrasiloxane, Methacrylate epoxy cyclosiloxane, Polyglycidyl ether cyclosiloxane and Acrylated Hexamethylcyclotrisiloxane.

12. The stamp according to any of claims 7 to 11, **characterized in that** said first part has a front face for printing and a back face opposite said front face, and said second part is arranged on said back face of said first part such that said first part is at least partially embedded in said second part.

13. The stamp according to claim 12, **characterized in that** said second part provides a margin extending beyond said first part, preferably all-around said first part, said margin allowing for conformal contact with a surface to be printed on.

14. The stamp according to any of claims 12 or 13, **characterized in that** said front face has a structured surface for printing.

15. A method of obtaining a stamp for imprint lithography, the method comprising: curing a cyclic siloxanes pre-polymer, such as a polymeric cyclic siloxane with at least one Oxide termination arm and at least three -CH3 termination arms, to form the stamp.
